# FASCICULE DE BREVET EUROPEEN

(11) **EP 3 360 396 B1**
(45) Date de publication et mention de la délivrance du brevet: **11.09.2019**
(21) Numéro de dépôt: 16790660.1
(22) Date de dépôt: 04.10.2016
(51) Int. Cl.: H05H 1/46, H01J 37/32

(54) **DISPOSITIF ÉLÉMENTAIRE DE PRODUCTION D'UN PLASMA AVEC APPLICATEUR COAXIAL ET INSTALLATION DE PRODUCTION DE PLASMA AVEC CE DISPOSITIF**
ELEMENTARE VORRICHTUNG ZUR ERZEUGUNG EINES PLASMAS MIT KOAXIALEM APPLIKATOR UND PLASMAEINRICHTUNG MIT DIESER VORRICHTUNG
ELEMENTARY DEVICE FOR PRODUCING A PLASMA HAVING A COAXIAL APPLICATOR AND PLASMA INSTALLATION WITH THIS DEVICE

(30) Priorité: 05.10.2015 FR 1559459
(43) Date de publication de la demande: 15.08.2018
(73) Titulaire: Sairem Societe Pour L'application Industrielle De La Recherche En Electronique Et Micro Ondes, 01700 Neyron (FR)
(72) Inventeur: LATRASSE, Louis, 69380 Dommartin (FR); RADOIU, Marilena, 69140 Rillieux-la-pape (FR)
(74) Mandataire: Chevalier, Renaud Philippe
(86) Numéro de dépôt international: PCT/FR2016/052546
(87) Numéro de publication internationale: WO 2017/060612

(56) Documents cités:
- WO-A1-03/103003
- WO-A1-2014/009412
- FR-A1- 2 955 451

## Description

La présente invention se rapporte à un dispositif élémentaire de production d'un plasma, et à une installation de production d'un plasma.

Elle se rapporte plus particulièrement à dispositif élémentaire de production d'un plasma comprenant un applicateur coaxial de puissance micro-onde.

Les installations de production de plasma à l'intérieur d'une enceinte de confinement trouvent des applications dans de nombreux domaines, tels que par exemple le nettoyage de surface, la stérilisation, le dépôt, notamment le dépôt chimique en phase vapeur assistée par plasma et le dépôt de diamant, la gravure, et autres traitements de surface tels que la pulvérisation ionique (ou pulvérisation cathodique).

Pour la transmission de l'énergie micro-onde entre un générateur et l'intérieur de l'enceinte, il est nécessaire d'employer au moins un dispositif élémentaire de production d'un plasma, et généralement une pluralité de tels dispositifs élémentaires en association, qui sont souvent appelés sources élémentaires.

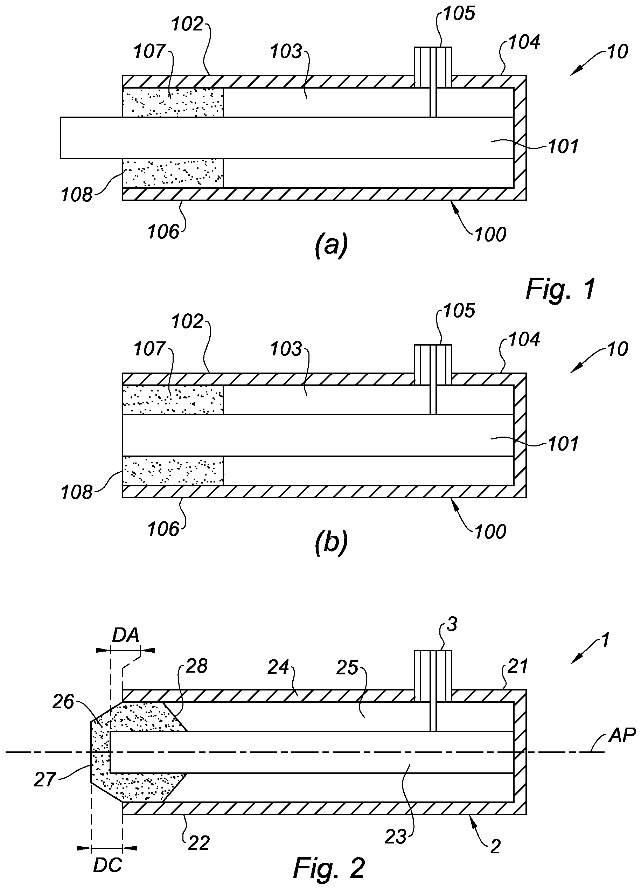

En référence aux figures 1(a) et 1(b), un dispositif élémentaire 10 classique comporte un applicateur coaxial 100 de puissance micro-onde qui permet de transmettre l'énergie micro-onde d'un guide d'onde ou câble coaxial vers l'enceinte; un tel applicateur coaxial 100 comportant une âme centrale 101 conductrice s'étendant selon un axe principal, un blindage externe 102 conducteur entourant l'âme centrale 101, un milieu de propagation 103 d'une énergie micro-onde situé entre l'âme centrale 101 et le blindage externe 102. Le blindage externe 102 présente une paroi périphérique, de préférence cylindrique, fermée à une extrémité distale 104 par une paroi de fond. L'applicateur coaxial 100 comprend en outre un système de couplage 105 avec le guide d'onde ou câble coaxial, ce système de couplage 105 étant disposé sur la paroi périphérique du blindage externe 102, à une distance donnée de la paroi de fond. Le blindage externe 102 est ouvert à une extrémité proximale 106 opposée prévue pour déboucher à l'intérieur d'une enceinte à plasma (non illustrée), cette extrémité proximale 106 ouverte étant bouchée par un corps isolant 107 en matériau diélectrique transparent à l'énergie micro-onde et présentant une surface externe 108 prévue pour être au contact avec un gaz à exciter localisé à l'intérieur de l'enceinte à plasma.

La liaison entre le milieu de propagation 103 et l'intérieur de l'enceinte à plasma nécessite en effet l'utilisation d'un corps isolant 107 diélectrique (par exemple en quartz, alumine, nitrure de bore, ...), qui assure, d'une part, le transport des micro-ondes en direction de l'enceinte et, d'autre part, l'étanchéité entre le milieu de propagation 103 et l'intérieur de l'enceinte qui est généralement à pression réduite par rapport à la pression atmosphérique ambiante.

Dans les deux exemples des figures 1(a) et 1(b), la surface externe 108 du corps isolant 107 est plane, quelle que soit la configuration de l'applicateur coaxial 100 avec l'âme centrale 101 qui traverse complètement le corps isolant 107 et dépasse de celui-ci (figure 1(a)), ou avec l'âme centrale 101 qui traverse le corps isolant 107 et dont l'extrémité vient en arasement avec la surface externe 108 (figure 1(b)).

Ainsi, la surface externe 108 du corps isolant 107 est plane, et la Demanderesse a constaté qu'une telle surface plane induit une transition très abrupte entre l'impédance du corps isolant 107 et l'impédance du plasma, ce qui va naturellement générer de la puissance réfléchie qui devra nécessairement être compensée par un adaptateur d'impédance en amont de l'applicateur coaxial.

Le document WO 2014/009412 divulgue quant à lui un dispositif élémentaire de production d'un plasma, comprenant un applicateur coaxial de puissance micro-onde comprenant une âme centrale conductrice s'étendant selon un axe principal, un blindage externe conducteur entourant l'âme centrale, un milieu de propagation d'une énergie micro-onde situé entre l'âme centrale et le blindage, où le blindage externe présente une extrémité proximale bouchée par un corps isolant en matériau diélectrique transparent à l'énergie micro-onde, où ce corps isolant se présente sous la forme d'un tube diélectrique qui présente une surface externe prévue pour être au contact avec un gaz à exciter localisé à l'intérieur d'une enceinte, et où le corps isolant dépasse extérieurement du blindage selon l'axe principal.

Cependant, dans ce document WO 2014/009412, la surface externe du tube diélectrique est cylindrique, de diamètre constant jusqu'à son sommet, et ce corps isolant dépasse du blindage sur une grande longueur (supérieure à son propre diamètre externe), car ce tube diélectrique est dessinée et conformé pour remplir une fonction d'applicateur à onde de surface, autrement dit pour que l'onde (ou l'énergie micro-onde) se propage entre le tube diélectrique et le plasma, et c'est ainsi pourquoi ce tube diélectrique dépasse hors du blindage d'une longueur au moins du double de son diamètre externe.

Dans le cadre de l'invention, l'objectif est d'optimiser la forme du corps isolant, non pas pour augmenter la propagation de l'énergie micro-onde entre sa propre surface et le plasma, mais plutôt pour favoriser la pénétration de l'énergie micro-onde dans le plasma en limitant la puissance réfléchie.

La présente invention a pour but de résoudre les inconvénients mentionnés ci-dessus et, à cet effet, elle propose un dispositif élémentaire de production d'un plasma, comprenant un applicateur coaxial de puissance micro-onde comprenant une âme centrale conductrice s'étendant selon un axe principal, un blindage externe conducteur entourant ladite âme centrale, un milieu de propagation d'une énergie micro-onde situé entre l'âme centrale et le blindage externe, un système de couplage avec un générateur d'énergie micro-onde, où ledit blindage externe présente une extrémité proximale bouchée par un corps isolant en matériau diélectrique transparent à l'énergie micro-onde et présentant une surface externe prévue pour être au contact avec un gaz à exciter localisé à l'intérieur d'une enceinte à plasma, ladite surface externe présentant une symétrie de révolution autour dudit axe principal, où le corps isolant dépasse extérieurement du blindage selon l'axe principal, ledit dispositif étant remarquable en ce que ladite surface externe est non plane et saille hors du blindage en présentant un diamètre externe décroissant le long de l'axe principal en partant du blindage jusqu'à son sommet.

Ainsi, en situation, le corps isolant pénètre à l'intérieur de l'enceinte à plasma, et sa surface externe non plane permet de créer un volume de plasma contrôlé par la forme même de cette surface externe, et par là-même assurer une transition non abrupte entre l'impédance du corps isolant et l'impédance du plasma, ce qui va permettre de réduire la puissance réfléchie.

En outre, le corps isolant rétrécit au fur et à mesure de son éloignement vis-à-vis du blindage, autrement dit au fur et à mesure de sa pénétration à l'intérieur du gaz à exciter, avec l'avantage d'améliorer la transition entre l'impédance du corps isolant et l'impédance du plasma.

Selon une possibilité, le diamètre externe de la surface externe décroit de manière continue le long de l'axe principal en partant du blindage jusqu'à son sommet.

Ainsi, la surface externe ne présente pas de variation discontinue de son diamètre, autrement dit ne présente pas de palier, escalier ou cran, mais le corps isolant présente plutôt une surface externe continue jusqu'à son sommet, pour une optimisation du transfert d'énergie.

Dans une première réalisation, la surface externe du corps isolant présente une forme générale tronconique.

Dans cette première réalisation, deux possibilités sont envisageables :
- la surface externe du corps isolant présente une forme générale tronconique tronquée à son extrémité et présentant un sommet plat ou arrondi ; ou
- la surface externe du corps isolant présente une forme générale tronconique non tronquée à son extrémité et présentant un sommet pointu.

Dans une seconde réalisation, la surface externe du corps isolant présente une forme générale hémisphérique.

Selon une caractéristique, la surface externe du corps isolant ne présente pas de bord à angle droit.

Selon une autre caractéristique, l'âme centrale présente une extrémité proximale noyée à l'intérieur du corps isolant, sans traverser complètement ledit corps isolant.

Dans une réalisation particulière, l'extrémité proximale de l'âme centrale dépasse du blindage selon l'axe principal.

Ainsi, l'âme centrale est plus longue que le blindage.

Selon une possibilité, le corps isolant et le blindage sont de révolution autour d'un axe principal commun, et le diamètre externe maximal du corps isolant est sensiblement équivalent ou supérieur au diamètre externe du blindage.

Avantageusement, le corps isolant présente une surface interne au contact avec le milieu de propagation et traversée par l'âme centrale, ladite surface interne étant non plane et non orthogonale par rapport à l'axe principal.

Selon une possibilité de l'invention, la surface interne présente un diamètre externe croissant le long de l'axe principal selon un sens de déplacement allant d'une extrémité distale de l'applicateur coaxial en direction d'une extrémité proximale bouchée par le corps isolant.

Selon une autre possibilité de l'invention, la surface interne du corps isolant présente une forme générale tronconique.

Dans une réalisation avantageuse, le corps isolant dépasse extérieurement du blindage selon l'axe principal d'une distance qui est inférieure ou égale au diamètre interne du blindage à son extrémité proximale.

Ainsi, le corps isolant saille sur une distance limitée, inférieure ou égale à son propre diamètre externe au niveau de l'extrémité proximale du blindage, pour une optimisation de la pénétration de l'énergie micro-onde, autrement dit pour une réduction des pertes et réflexions lors du transfert.

La présente invention concerne une installation de production d'un plasma comprenant :
- une enceinte dans le volume de laquelle le plasma est produit et confiné, ladite enceinte étant délimitée par une cloison ;
- au moins un générateur d'énergie micro-onde ;
- au moins un dispositif élémentaire conforme à l'invention, dont le système de couplage est couplé avec ledit générateur d'énergie micro-onde et dont la surface externe du corps isolant pénètre à l'intérieur de l'enceinte au-delà de sa cloison.

Selon une possibilité de l'invention, le blindage de l'applicateur coaxial est constitué d'une pièce rapportée sur l'enceinte et traversant de manière étanche sa cloison.

Selon une autre possibilité de l'invention, le blindage de l'applicateur coaxial vient de matière au moins partiellement avec la cloison.

D'autres caractéristiques et avantages de la présente invention apparaîtront à la lecture de la description détaillée ci-après, d'exemples de mise en oeuvre non limitatifs, faite en référence aux figures annexées dans lesquelles :
- les figures 1(a) et 1(b), déjà commentées, sont des vues schématiques en coupe axiale de deux dispositifs élémentaires classiques de production d'un plasma ;
- la figure 2 est une vue schématique en coupe axiale d'un premier dispositif élémentaire conforme à l'invention ;
- la figure 3 est une vue schématique en coupe axiale d'un deuxième dispositif élémentaire conforme à l'invention ;
- la figure 4 est une vue schématique en coupe axiale d'un troisième dispositif élémentaire conforme à l'invention ;
- la figure 5 est une vue schématique en perspective du premier dispositif élémentaire de la figure 2 ;
- la figure 6 est une vue schématique de l'intérieur d'une enceinte à plasma dans laquelle est placé le premier dispositif élémentaire des figures 2 et 5 ; et
- la figure 7 est une vue schématique de l'intérieur d'une enceinte à plasma dans laquelle sont placés plusieurs premiers dispositifs élémentaires des figures 2 et 5.

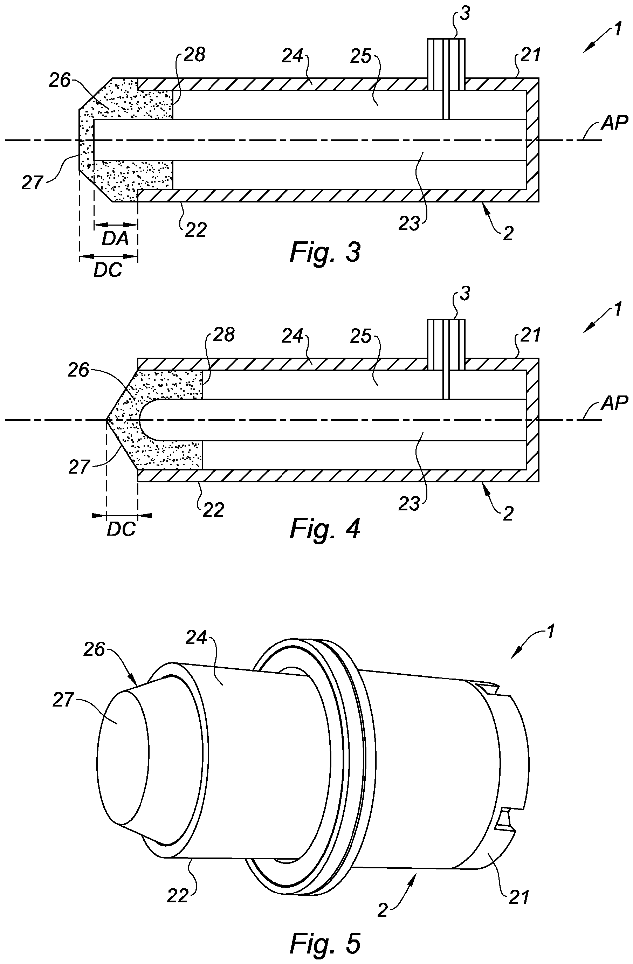

Les figures 2 à 5 illustrent trois modes de réalisation d'un dispositif élémentaire 1 de production d'un plasma, avec un premier mode de réalisation illustré sur les figures 2 et 5, un deuxième mode de réalisation illustré sur la figure 3 et un troisième mode de réalisation illustré sur la figure 4, et, sauf indication explicite ou implicite contraire, des organes, pièces, dispositifs ou éléments structurellement ou fonctionnellement identiques ou similaires seront désignés par des repères identiques sur ces figures.

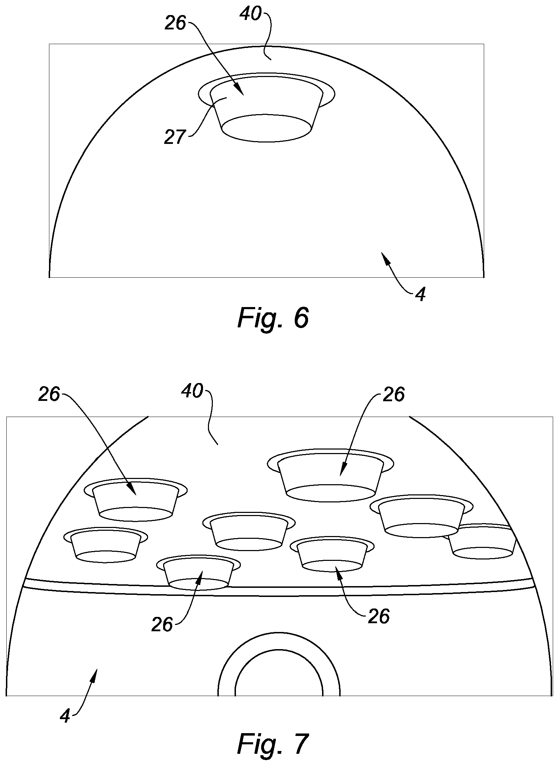

Le dispositif élémentaire 1 comprend un applicateur coaxial 2 de puissance micro-onde, prévu pour assurer la transmission d'une énergie micro-onde entre un générateur d'énergie micro-onde (non illustré), notamment du type générateur à état solide, et l'intérieur d'une enceinte 4 à plasma (visible sur les figures 6 et 7).

Cet applicateur coaxial 2 est réalisé sous une forme filaire, c'est-à-dire allongée selon un axe principal AP, et il présente :
- une extrémité distale 21 ; et
- une extrémité proximale 22 opposée prévue pour déboucher à l'intérieur de l'enceinte 4.

L'applicateur coaxial 2 comprend :
- une âme centrale 23 conductrice s'étendant selon l'axe principal AP, et se présentant sous la forme d'une tige, et notamment d'une tige de section transversale constante ;
- un blindage 24 externe conducteur entourant l'âme centrale 23, ce blindage externe 24 se présentant sous la forme d'un manchon creux comprenant une paroi périphérique présentant une face interne cylindrique centrée sur l'axe principal AP, et une paroi de fond fermant l'extrémité distale 21 de l'applicateur coaxial 2 ;
- un milieu de propagation 25 de l'énergie micro-onde situé entre l'âme centrale 23 et le blindage 24, ce milieu de propagation 25 étant par exemple composé d'air ; et
- un corps isolant 26 en matériau diélectrique transparent à l'énergie micro-onde, ce corps isolant 26 étant disposé sur l'extrémité proximale 22 de l'applicateur coaxial 2.

A l'extrémité proximale 22, le blindage 24 présente une extrémité proximale ouverte bouchée par le corps isolant 26 qui garantit l'étanchéité entre le milieu de propagation 25 et l'intérieur de l'enceinte 4.

L'applicateur coaxial 2 comprend en outre un système de couplage 3 avec le générateur d'énergie micro-onde. Ce système de couplage 3 est constitué de tous moyens appropriés assurant la connexion avec un câble coaxial ou un guide d'onde (non illustré) reliant le générateur au système de couplage 3.

Dans l'exemple des figures 2 à 4, le système de couplage 3 est conçu pour le couplage avec un câble coaxial et, à cet effet, présente une structure du type structure coaxiale ; une telle structure coaxiale comprenant classiquement un conducteur externe au contact avec le blindage 24 (décrit ci-après) de l'applicateur coaxial 2 et entourant un conducteur interne qui vient au contact avec l'âme centrale 23 (décrite ci-après) de l'applicateur coaxial 2.

Ce système de couplage 3 peut être positionné sur la paroi de fond du blindage 24, ou bien sur sa paroi périphérique.

Le corps isolant 26 bouche complètement l'extrémité proximale 22 de l'applicateur coaxial 2, séparant ainsi l'intérieur de l'enceinte 4, qui est souvent maintenue à basse pression, du milieu de propagation 25, qui est à la pression atmosphérique ambiante.

Le corps isolant 26 est une pièce de révolution autour de l'axe principal AP, et présente une surface externe 27 prévue pour être au contact avec l'intérieur de l'enceinte 4, et plus précisément avec un gaz à exciter localisé à l'intérieur de l'enceinte 4.

En outre, ce corps isolant 26 dépasse extérieurement du blindage 24 selon l'axe principal AP d'une distance DC, et sa surface externe 27 est non plane et saille hors du blindage 24 de cette distance DC.

Cette distance DC est inférieure ou égale au diamètre interne du blindage 24 à son extrémité proximale ; étant entendu par diamètre interne de l'extrémité proximale du blindage 24 le diamètre de sa face interne périphérique ou cylindrique qui est en contact avec le corps isolant 26. Ainsi, cette distance DC est inférieure ou égale au diamètre externe du corps isolant 26 pris à l'extrémité proximale du blindage 24.

Cette surface externe 27 est ainsi bombée vers l'extérieur du blindage 24, sans bord à angle droit, et elle présente une symétrie de révolution autour de l'axe principal AP.

De manière générale, le diamètre de cette surface externe 27 décroit de manière continue (c'est-à-dire sans marche, cran ou palier) le long de l'axe principal AP en partant du blindage 24 jusqu'à son sommet.

Cette surface externe 27 présente par exemple une forme générale tronconique tronquée à son extrémité et présentant un sommet plat (comme visible sur les figures 2, 3 et 5), ou une forme générale tronconique non tronquée à son extrémité et présentant un sommet pointu (comme visible sur la figure 4).

Il est à noter que la surface externe 27 présente une forme générale tronconique droite (avec une génératrice rectiligne, comme illustré sur les figures 2 à 7), ou bien concave ou convexe (avec une génératrice incurvée).

Dans des variantes non illustrées, la surface externe 27 présente une forme générale tronconique tronquée à son extrémité et présentant un sommet arrondi, ou bien présente une forme générale hémisphérique.

De manière générale, la surface externe 27 présente un diamètre externe décroissant le long de l'axe principal AP en partant du blindage 24 jusqu'à son sommet (ou jusqu'à son extrémité libre). Ainsi, en s'éloignant du blindage 24 (et donc en s'enfonçant à l'intérieur de l'enceinte 4), le diamètre externe de la surface externe 27 diminue, par exemple de manière régulière (surface tronconique) ou de manière irrégulière.

De plus, le corps isolant 26 présente également une surface interne 28 au contact avec le milieu de propagation 25, entourée complètement par le blindage 28 et traversée par l'âme centrale 23 ; cette surface interne 28 étant la surface transversale qui est au contact du milieu de propagation 25.

Cette surface interne 28 peut être plane et perpendiculaire à l'axe principal AP, comme visible dans les modes de réalisation des figures 3 et 4.

De manière avantageuse et comme visible dans le mode de réalisation de la figure 2, cette surface interne 28 peut être non plane. Cette surface interne 28 est non plane pour les même raisons que celles mentionnées pour la surface externe 27, c'est-à-dire favoriser la pénétration des ondes du milieu de propagation 25 au gaz à exciter à travers le corps isolant 26, et éviter les ruptures abruptes d'impédances et éviter de générer inutilement de la puissance réfléchie.

De manière générale, la surface interne 28 est non orthogonale par rapport à l'axe principal AP et présente un diamètre externe croissant le long de l'axe principal AP selon un sens de déplacement allant de l'extrémité distale 21 en direction de l'extrémité proximale 22 bouchée par le corps isolant 26.

Cette surface interne 28 présente par exemple une forme générale tronconique, et plus précisément une forme générale tronconique droite (avec une génératrice rectiligne, comme illustré sur la figure 2), ou bien concave ou convexe (avec une génératrice incurvée).

Dans les exemples de réalisation illustrés sur les figures 2 à 4, l'âme centrale 23 présente une extrémité proximale noyée à l'intérieur du corps isolant 26, sans traverser complètement ce corps isolant 26.

Dans les exemples des figures 2 et 3, l'extrémité proximale de l'âme centrale 23 dépasse du blindage 24 selon l'axe principal AP d'une distance DA inférieure à la distance DC.

Dans l'exemple de la figure 4, l'extrémité proximale de l'âme centrale 23 se situe dans l'alignement de l'extrémité proximale du blindage 24, et ne dépasse donc pas du blindage 24.

Dans les exemples des figures 2 et 4, le diamètre externe maximal du corps isolant 26 est sensiblement équivalent au diamètre interne du blindage 24. Dans l'exemple de la figure 3, le diamètre externe maximal du corps isolant 26 est sensiblement équivalent au diamètre externe du blindage 24, de sorte que le corps isolant 26 présente un épaulement prolongé par une section de diamètre réduit sensiblement équivalent au diamètre interne du blindage 24, cette section venant s'emmancher à l'intérieur du blindage 24.

Dans des variantes non illustrées, l'extrémité proximale de l'âme centrale 23 se situe en retrait (sur l'intérieur du blindage 24) par rapport à l'extrémité proximale du blindage 24.

Dans des variantes non illustrées, le diamètre externe maximal du corps isolant 26 est supérieur au diamètre externe du blindage 24. Dans le cas où le diamètre externe maximal du corps isolant 26 est équivalent ou supérieur au diamètre externe du blindage 24, il est également envisageable que le corps isolant 26 soit en partie en contact avec la cloison 40 de l'enceinte 4.

Un tel dispositif élémentaire 1 est employé dans une installation de production d'un plasma comprenant :
- l'enceinte 4 dans le volume de laquelle le plasma est produit et confiné, cette enceinte étant délimitée par une cloison 40 ;
- au moins un générateur d'énergie micro-onde (non illustrés), notamment du type générateur à état solide ;
- au moins un câble coaxial ou guide d'onde (non illustré) raccordé d'une part au générateur et d'autre part au système de couplage 3 d'un dispositif élémentaire 1 ; et
- au moins un dispositif élémentaire 1 dont la surface externe 27 du corps isolant 26 pénètre à l'intérieur de l'enceinte au-delà de sa cloison 40, comme visible sur les figures 6 et 7.

Il est à noter que le blindage 24 de l'applicateur coaxial 2 :
- soit est constitué d'une pièce rapportée sur l'enceinte 4 et traversant de manière étanche sa cloison 40 ;
- soit vient de matière au moins partiellement avec la cloison 40, autrement dit ce blindage 24 est formé partiellement ou totalement par la cloison 40 elle-même.

## Revendications

1. Dispositif élémentaire (1) de production d'un plasma, comprenant un applicateur coaxial (2) de puissance micro-onde comprenant une âme centrale (23) conductrice s'étendant selon un axe principal (AP), un blindage (24) externe conducteur entourant ladite âme centrale (23), un milieu de propagation (25) d'une énergie micro-onde situé entre l'âme centrale (23) et le blindage (24), un système de couplage (3) avec un générateur d'énergie micro-onde, ledit système de couplage (3) étant disposé sur le blindage externe (24), où ledit blindage externe (24) présente une extrémité proximale bouchée par un corps isolant (26) en matériau diélectrique transparent à l'énergie micro-onde et présentant une surface externe (27) prévue pour être au contact avec un gaz à exciter localisé à l'intérieur d'une enceinte (4), ladite surface externe (27) présentant une symétrie de révolution autour dudit axe principal (AP), où le corps isolant (26) dépasse extérieurement du blindage (24) selon l'axe principal (AP), et où ladite surface externe (27) est non plane et saille hors du blindage (24), ledit dispositif élémentaire (1) étant **caractérisé en ce que** ladite surface externe (27) présente un diamètre externe décroissant le long de l'axe principal (AP) en partant du blindage (24) jusqu'à son sommet.

2. Dispositif élémentaire (1) selon la revendication 1, dans lequel le diamètre externe de la surface externe (27) décroit de manière continue le long de l'axe principal (AP) en partant du blindage (24) jusqu'à son sommet.

3. Dispositif élémentaire (1) selon la revendication 2, dans lequel la surface externe (27) du corps isolant (26) présente une forme générale tronconique ou hémisphérique.

4. Dispositif élémentaire (1) selon la revendication 3, dans lequel la surface externe (27) du corps isolant (26) présente une forme générale tronconique tronquée à son extrémité et présentant un sommet plat ou arrondi, ou une forme générale tronconique non tronquée à son extrémité et présentant un sommet pointu.

5. Dispositif élémentaire (1) selon l'une quelconque des revendications précédentes, dans lequel la surface externe (27) du corps isolant (26) ne présente pas de bord à angle droit.

6. Dispositif élémentaire (1) selon l'une quelconque des revendications précédentes, dans lequel l'âme centrale (23) présente une extrémité proximale noyée à l'intérieur du corps isolant (26), sans traverser complètement ledit corps isolant (26).

7. Dispositif élémentaire (1) selon la revendication 6, dans lequel l'extrémité proximale de l'âme centrale (23) dépasse du blindage (24) selon l'axe principal (AP).

8. Dispositif élémentaire (1) selon l'une quelconque des revendications précédentes, dans lequel le corps isolant (26) et le blindage (24) sont de révolution autour de l'axe principal (AP) commun, et le diamètre externe maximal du corps isolant (26) est sensiblement équivalent ou supérieur au diamètre externe du blindage (24).

9. Dispositif élémentaire (1) selon l'une quelconque des revendications précédentes, dans lequel le corps isolant (26) présente une surface interne (28) au contact avec le milieu de propagation (25) et traversée par l'âme centrale (23), ladite surface interne (28) étant non plane et non orthogonale par rapport à l'axe principal (AP).

10. Dispositif élémentaire (1) selon la revendication 9, dans lequel la surface interne (28) présente un diamètre externe croissant le long de l'axe principal (AP) selon un sens de déplacement allant d'une extrémité distale (21) de l'applicateur coaxial (2) en direction d'une extrémité proximale (22) bouchée par le corps isolant (26).

11. Dispositif élémentaire (1) selon les revendications 9 ou 10, dans lequel la surface interne (28) du corps isolant (26) présente une forme générale tronconique.

12. Dispositif élémentaire (1) selon l'une quelconque des revendications précédentes, dans lequel le corps isolant (26) dépasse extérieurement du blindage (24) selon l'axe principal (AP) d'une distance (DC) qui est inférieure ou égale au diamètre interne du blindage (24) à son extrémité proximale.

13. Installation de production d'un plasma comprenant :
- une enceinte (4) dans le volume de laquelle le plasma est produit et confiné, ladite enceinte (4) étant délimitée par une cloison (40) ;
- au moins un générateur d'énergie micro-onde ;
- au moins un dispositif élémentaire (1) conforme à l'une quelconque des revendications précédentes, dont le système de couplage (3) est couplé avec ledit générateur d'énergie micro-onde et dont la surface externe (27) du corps isolant (26) pénètre à l'intérieur de l'enceinte (4) au-delà de sa cloison (40).

14. Installation selon la revendication 13, dans lequel le blindage (24) de l'applicateur coaxial (2) soit est constitué d'une pièce rapportée sur l'enceinte (4) et traversant de manière étanche sa cloison (40), soit vient de matière au moins partiellement avec la cloison (40).

## Patentansprüche

1. Elementare Vorrichtung (1) zur Herstellung eines Plasmas, umfassend einen koaxialen Applikator (2) von Mikrowellenleistung, umfassend einen leitenden, sich entlang einer Hauptachse (AP) erstreckenden Zentralkern (23), eine leitende, den Zentralkern (23) umschließende äußere Abschirmung (24), ein Ausbreitungsmedium (25) einer Mikrowellenenergie, welches sich zwischen dem Zentralkern (23) und der Abschirmung (24) befindet, ein Kopplungssystem (3) mit einem Mikrowellenenergie-Generator, wobei das Kopplungssystem (3) auf der äußeren Abschirmung (24) angeordnet ist, wobei die äußere Abschirmung (24) ein proximales Ende aufweist, welches verschlossen wird von einem Isolierkörper (26) aus dielektrischem Material, welches für die Mikrowellenenergie durchlässig ist, und eine Außenoberfläche (27) aufweist, welche dafür vorgesehen ist, mit einem erregenden Gas in Kontakt zu sein, welches sich im Inneren eines Gehäuses (4) befindet, wobei die Außenoberfläche (27) eine Rotationssymmetrie um die Hauptachse (AP) aufweist, wobei der Isolierkörper (26) entlang der Hauptachse (AP) über die Abschirmung (24) hinausragt, und wobei die Außenoberfläche (27) nicht flach ist und außerhalb der Abschirmung (24) hervorsteht, wobei die elementare Vorrichtung (1) **dadurch gekennzeichnet ist, dass** die Außenoberfläche (27) einen Außendurchmesser aufweist, welcher sich angefangen bei der Abschirmung (24) bis zu seinem Scheitel entlang der Hauptachse (AP) verkleinert.

2. Elementare Vorrichtung (1) nach Anspruch 1, wobei sich der Außendurchmesser der Außenoberfläche (27) angefangen bei der Abschirmung (24) bis zu seinem Scheitel entlang der Hauptachse (AP) auf kontinuierliche Weise verkleinert.

3. Elementare Vorrichtung (1) nach Anspruch 2, wobei die Außenoberfläche (27) des Isolierkörpers (26) eine kegelstumpfförmige oder kreisförmige allgemeine Form aufweist.

4. Elementare Vorrichtung (1) nach Anspruch 3, wobei die Außenoberfläche (27) des Isolierkörpers (26) eine kegelstumpfförmige, an ihrem Ende abgeschnittene und einen flachen oder abgerundeten Scheitel aufweisende allgemeine Form aufweist, oder eine kegelstumpfförmige, an ihrem Ende nicht abgeschnittene und einen spitzen Scheitel aufweisende allgemeine Form.

5. Elementare Vorrichtung (1) nach einem der vorhergehenden Ansprüche, wobei die Außenoberfläche (27) des Isolierkörpers (26) keine rechtwinklige Kante aufweist.

6. Elementare Vorrichtung (1) nach einem der vorhergehenden Ansprüche, wobei der Zentralkern (23) ein proximales Ende aufweist, welches in das Innere des Isolierkörpers (26) eingebettet ist, ohne den Isolierkörper (26) vollständig zu durchqueren.

7. Elementare Vorrichtung (1) nach Anspruch 6, wobei das proximale Ende des Zentralkerns (23) entlang der Hauptachse (AP) über die Abschirmung (24) ragt.

8. Elementare Vorrichtung (1) nach einem der vorhergehenden Ansprüche, wobei sich der Isolierkörper (26) und die Abschirmung (24) in Rotation um die gemeinsame Hauptachse (AP) befinden und der maximale Außendurchmesser des Isolierkörpers (26) im Wesentlichen gleich wie oder größer als der Außendurchmesser der Abschirmung (24) ist.

9. Elementare Vorrichtung (1) nach einem der vorhergehenden Ansprüche, wobei der Isolierkörper (26) eine in Kontakt mit dem Ausbreitungsmedium (25) stehende und von dem Zentralkern (23) durchquerte Innenoberfläche (28) aufweist, wobei die Innenoberfläche (28) nicht flach und nicht orthogonal in Bezug auf die Hauptachse (AP) ist.

10. Elementare Vorrichtung (1) nach Anspruch 9, wobei die Innenoberfläche (28) einen Außendurchmesser aufweist, welcher sich entlang der Hauptachse (AP) gemäß einer Bewegungsrichtung vergrößert, welche von einem distalen Ende (21) des koaxialen Applikators (2) in Richtung eines von dem Isolierkörper (26) verschlossenen proximalen Endes (22) verläuft.

11. Elementare Vorrichtung (1) nach Anspruch 9 oder 10, wobei die Innenoberfläche (28) des Isolierkörpers (26) eine kegelstumpfförmige allgemeine Form aufweist.

12. Elementare Vorrichtung (1) nach einem der vorhergehenden Ansprüche, wobei der Isolierkörper (26) entlang der Hauptachse (AP) über die Abschirmung (24) mit einem Abstand (DC) hinausragt, der niedriger als oder gleich wie der Innendurchmesser der Abschirmung (24) an ihrem proximalen Ende ist.

13. Installation zur Herstellung eines Plasmas, Folgendes umfassend:
- ein Gehäuse (4), in dessen Volumen das Plasma hergestellt und eingeschlossen wird, wobei das Gehäuse (4) durch eine Trennwand (40) begrenzt ist;
- wenigstens einen Mikrowellenenergie-Generator;
- wenigstens eine elementare Vorrichtung (1) nach einem der vorhergehen Ansprüche, deren Kopplungssystem (3) mit dem Mikrowellenenergie-Generator gekoppelt ist und deren Außenoberfläche (27) des Isolierkörpers (26) in das Innere des Gehäuses (4) jenseits seiner Trennwand (40) eindringt.

14. Installation nach Anspruch 13, wobei die Abschirmung (24) des koaxialen Applikators (2) entweder aus einem mit dem Gehäuse (4) verbundenen und dessen Trennwand (40) auf dichte Weise durchquerenden Stück besteht, oder wenigstens teilweise aus einem Stück mit der Trennwand (40) geformt ist.

## Claims

1. An elementary device (1) for producing a plasma, comprising a coaxial applicator (2) of microwave power comprising a conductive central core (23) extending along a main axis (AP), a conductive outer shield (24) surrounding said central core (23), a propagation medium (25) for propagating a microwave energy located between the central core (23) and the shield (24), a coupling system (3) for coupling to a microwave energy generator, said coupling system (3) being disposed on the outer shield (24), where said outer shield (24) has a proximal end occluded by an insulating body (26) made of dielectric material transparent to the micro-wave energy and having an outer surface (27) intended to be in contact with a gas to be energized localized inside a chamber (4), said outer surface (27) having a symmetry of revolution about said main axis (AP), wherein the insulating body (26) protrudes outwardly of the shield (24) according to the main axis (AP), and wherein said outer surface (27) is non-planar and projects outside of the shield (24), said elementary device (1) being **characterized in that** the outer surface (27) has an outer diameter decreasing along the main axis (AP) starting from the shield (24) up to its tip.

2. The elementary device (1) according to claim 1, wherein the outer diameter of the outer surface (27) decreases continuously along the main axis (AP) starting from the shield (24) up to its tip.

3. The elementary device (1) according to claim 2, wherein the outer surface (27) of the insulating body (26) has a generally truncated-cone or hemispherical shape.

4. The elementary device (1) according to claim 3, wherein the outer surface (27) of the insulating body (26) has a generally truncated-cone shape truncated at its end and having a flat or rounded tip, or a generally truncated-cone shape not truncated at its end and having a sharp tip.

5. The elementary device (1) according to any one of the preceding claims, wherein the outer surface (27) of the insulating body (26) has no right-angled edges.

6. The elementary device (1) according to any one of the preceding claims, wherein the central core (23) has a proximal end embedded inside the insulating body (26), without passing completely through said insulating body (26).

7. The elementary device (1) according to claim 6, wherein the proximal end of the central core (23) protrudes from the shield (24) according to the main axis (AP).

8. The elementary device (1) according to any one of the preceding claims, wherein the insulating body (26) and the shield (24) revolve about the common main axis (AP), and the maximum outer diameter of the insulating body (26) is substantially equivalent to or larger than the outer diameter of the shield (24).

9. The elementary device (1) according to any one of the preceding claims, wherein the insulating body (26) has an inner surface (28) in contact with the propagation medium (25) and crossed by the central core (23), said inner surface (28) being non-planar and non-orthogonal to the main axis (AP).

10. The elementary device (1) according to claim 9, wherein the inner surface (28) has an increasing outer diameter along the main axis (AP) in a direction of displacement from a distal end (21) of the coaxial applicator (2) towards a proximal end (22) occluded by the insulating body (26).

11. The elementary device (1) according to claims 9 or 10, wherein the inner surface (28) of the insulating body (26) has a generally truncated-cone shape.

12. The elementary device (1) according to any one of the preceding claims, wherein the insulating body (26) protrudes outwardly of the shield (24) according to the main axis (AP) by a distance (DC) which is smaller than or equal to the inner diameter of the shield (24) at its proximal end.

13. An installation for producing a plasma comprising:
- a chamber (4) within which the plasma is produced and confined, said chamber (4) being delimited by a partition (40);
- at least one microwave energy generator;
- at least one elementary device (1) in accordance with any one of the preceding claims, whose coupling system (3) is coupled with said microwave energy generator and whose outer surface (27) of the insulating body (26) penetrates inside the chamber (4) beyond its partition (40).

14. The installation according to claim 13, wherein the shield (24) of the coaxial applicator (2) is either constituted by a part attached onto the chamber (4) and crossing its partition (40) in a sealed manner, or is integrally formed at least partially with the partition (40).
